## Europäisches Patentamt
## European Patent Office
## Office européen des brevets

(11) Publication number: **0 237 176**
**A2**

(12) **EUROPEAN PATENT APPLICATION**

(21) Application number: 87301030.0

(22) Date of filing: 05.02.87

(51) Int. Cl.³: **H 05 K 1/11**

(30) Priority: 07.02.86 JP 25346/86
07.02.86 JP 25347/86

(43) Date of publication of application:
16.09.87 Bulletin 87/38

(84) Designated Contracting States:
DE ES FR GB IT NL SE

(71) Applicant: MINNESOTA MINING AND
MANUFACTURING COMPANY
3M Center, P.O. Box 33427
St. Paul, Minnesota 55133-3427(US)

(72) Inventor: Hagiwara, Yoshichi c/o Minnesota Mining and
Manufacturing Co. 2501 Hudson Road P.O. Box 33427
St. Paul Minnesota 55133-3427(US)

(72) Inventor: Hirasawa, Yuji c/o Minnesota Mining and
Manufacturing Co. 2501 Hudson Road P.O. Box 33427
St. Paul Minnesota 55133-3427(US)

(72) Inventor: Kimura, Naoya c/o Minnesota Mining and
Manufacturing Co. 2501 Hudson Road P.O. Box 33427
St. Paul Minnesota 55133-3427(US)

(72) Inventor: Emori, Kenji c/o Minnesota Mining and
Manufacturing Co. 2501 Hudson Road P.O. Box 33427
St. Paul Minnesota 55133-3427(US)

(72) Inventor: Kawamoto, Yoshitaka c/o Minnesota Mining
and
Manufacturing Co. 2501 Hudson Road P.O. Box 33427
St. Paul Minnesota 55133-3427(US)

(74) Representative: Baillie, Iain Cameron et al,
c/o Ladas & Parry Isartorplatz 5
D-8000 München 2(DE)

(54) Connector with fine-pitched conductive passages.

(57) The present invention provides a connector comprising conductive passages which are at least partially of 0.5 mm or less in width, the fine pitched conductive passages are formed on a base film and coated by substantially insulative adhesive melting at lower temperatures than that of the base film. The conductive passages preferably contain fine convexes and concaves on their surfaces and preferably are made of a metallic material.

The present invention also provides a method for making electrical connection by heating and pressing two pairs of diametrically opposed connectors of the present invention by use of substantially insulative adhesive by providing the adhesive between diametrically opposed connectors.

FIG.1c

## CONNECTOR WITH FINE-PITCHED CONDUCTIVE PASSAGES

### Technical Field

This invention relates to connectors which provide electrical continuity between members facing each other such as connection between large scale integrated circuits (LSI) and printed circuit boards or between electrical circuits and lead wires. This invention also relates to a method of making electrical connection with electrical connectors of the invention.

### Background Art

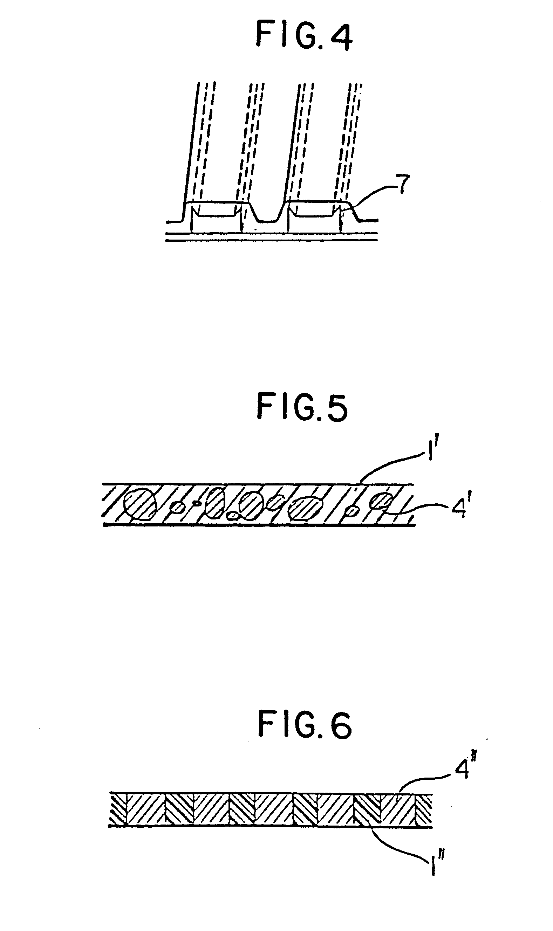

Conventionally, electrical connection between members facing each other is made by soldering or by using a conductive adhesive sheet (Refer to Japanese Patent Kokai Laid-Open Publn. 21192/'76) made by forming conductive layer of thickness equal to the diameter of conductive particles (4') dispersed in insulative resin (1') as illustrated in Fig. 5, or by using laminated connectors sliced into desired thickness as illustrated in Fig. 6, made by alternately laminating the layer of conductive material 4" having carbon particles dispersed in organic binder and the insulative layer 1" mainly composed of organic binder (Refer to Japanese Patent Kokai Laid-Open Publn. 141807/'82).

A flexible connector comprising an adhesive resin containing conductive particles on the plurality of linear or belt type conductive passages formed on the substrate is disclosed by Japanese Patent Kokai (Laid-Open Publn) 154778/'83. In this connector electrical connection is made simply by applying heat and pressure on the connector placed on facing members.

The above mentioned soldering method requires a close attention and skill to prevent short circuit with adjacent conductors, which decreases workability.

The conductive adhesive sheet made of forming a conductive layer of thickness roughly equal to the diameter of the conductive particles (4') shown in Fig. 5 distributed over the insulative resin (1') has the following drawbacks.

(a) It is difficult to completely prevent secondary coagulation of the conductive particles when dispersing the conductive particles in the insulative resin and to maintain insulation between the plurality of conductors.

(b) Even though the conductive particles may be completely dispersed it is difficult to prevent short-circuiting of adjacent conductive passages when the distance between the adjacent conductive passages is, for example, 0.2 mm or less, conductive particles are likely to form bridges between the adjacent conductive passages.

(c) The diameters of the conductive particles have to be 5 to 100 $\mu$m in order to prevent the secondary coagulation but large conductive particles are hard to be evenly dispersed since they have tendency to precipitate.

(d) In forming the conductive adhesive sheet by extrusion without solvent, it would be difficult to get the sheet free of defects since the conductive particles cannot pass smoothly through the slit of the extruder.

As described above, it is not easy to obtain a highly reliable conductive sheet having conductive particles individually insulated, making its use limited to the connection of members with the comparatively wide spaces between adjacent conductive passages.

The laminated connector illustrated in Fig. 6 is made by alternately laminating layers of conductive (4") having the carbon particles scattered over the organic binder and the insulative layer 1" and sliced to the desired thickness requires an added process of slicing after laminating the conductors and insulators, though this process produces conductive layer of uniform thickness. Moreover, a mechanical connecting tool, such as a clip, is needed to connect the facing members making it difficult to make the connector compact. The application may be limited to liquid crystal display and the like since electrical continuity is obtained through conductive particles, such as carbon particles, which increases resistance.

The flexible connector described in Japanese Patent Kokai Laid-Open Publn. 154778/'83 has limited width and pitches of the conductive passages due to manufacturing convenience and connectors with fine pitches can not be made. Since the conductive particles are not fixed on the conductive passages, the adhesive containing conductive particles is likely to shift positions during bonding operation with heat and pressure, causing short-circuit of adjacent terminals.

The present invention solves the above problems of the prior art methods and provides a low-resistance connector with a high reliability for connecting members having fine pitched conductive passages.

## Disclosure of the Invention

The present invention provides a connector comprising conductive passages which are at least partially of 0.5 mm or less in width, the fine pitched conductive passages formed on a base film and coated by a substantially insulative adhesive melting at lower temperatures than that of the base film. The conductive passages preferably contain fine convexes and concaves on their surfaces and preferably are made of a metallic material.

The present invention also provides a method for making electrical connection by heating and pressing two pairs of diametically opposed connectors of the present invention by use of substantially insulative adhesive by
providing the adhesive between diametrically opposed
conductors.


Brief Description of the Drawings

Figures 1(a)-(c) illustrate the connector of the
present invention, (a) is a cross section, (b) is a plane
view and (c) a perspective view;

Figure 2 is a perspective view of a connector of
the present invention;

Figure 3 is a perspective view of a connector of
the present invention;

Figure 4 is a perspective view of a connector of
the present invention;

Figure 5 is a cross-section of a prior art
adhesive tape;

Figure 6 is a cross-section of a prior art
laminated connector;

Figures 7 (a),(b) illustrate the formation of the
conductive passages of the connector of the present
invention;

Figure 8 is a perspective view of an embodiment
of the conductive passages of the present invention;

Figure 9 is a graph showing the effect of surface
coarseness of the conductive passages of the present
invention; and

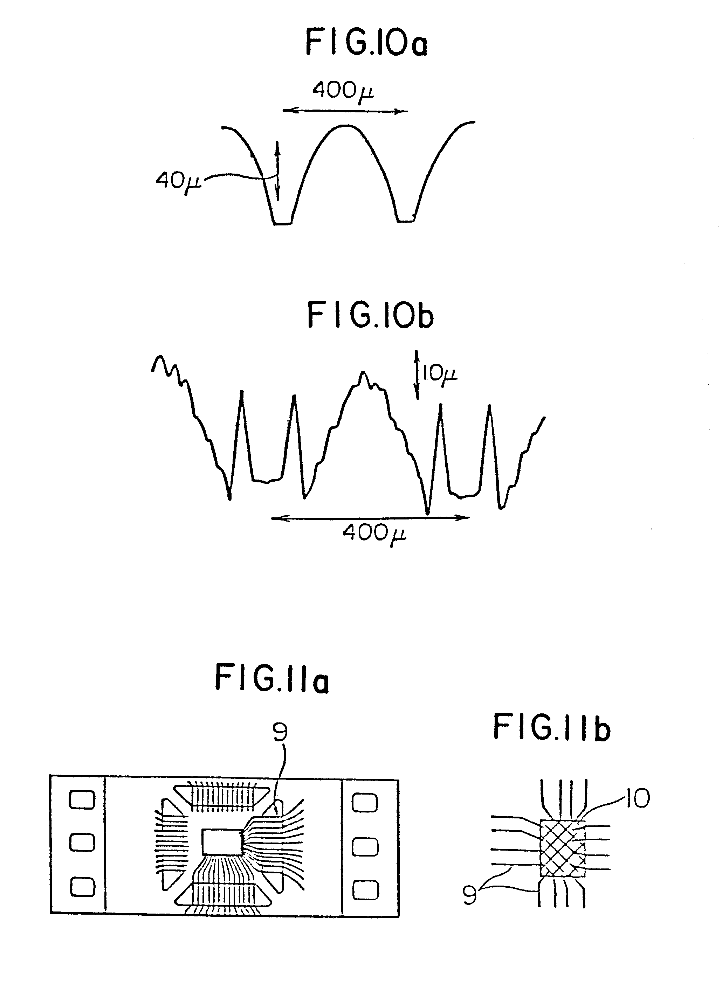

Figure 10 illustrates the surface coarseness of a
connector after embossing.

Figure 11 shows a tape carrier (a) showing the
entire drawing and, (b) enlargement of a part.


Detailed Description

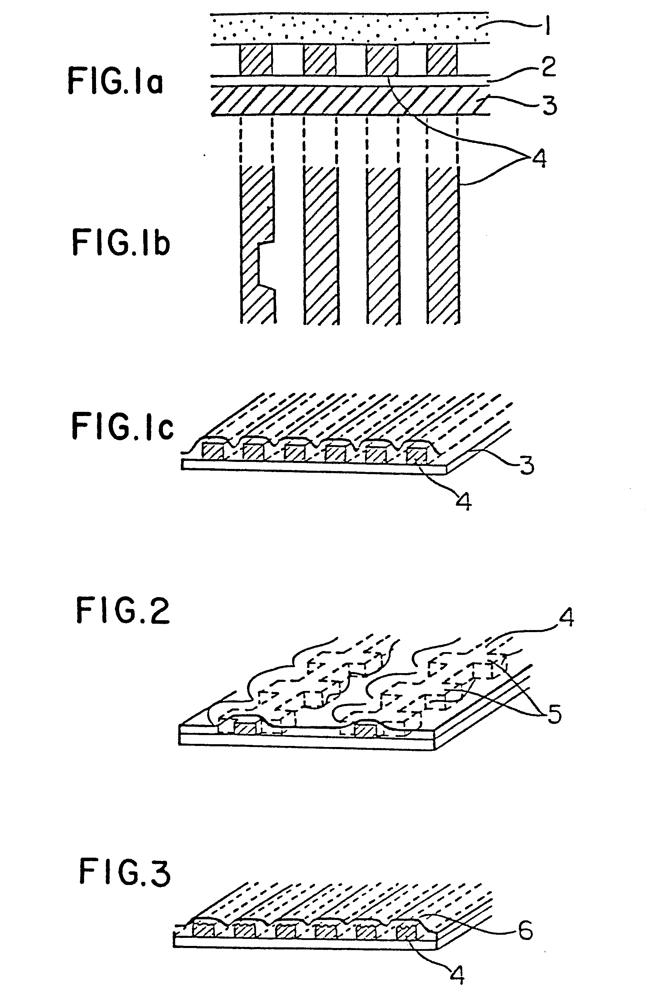

The present invention is described by referring
to Figures 1,(a), (b) and (c).  The invention provides a
connector having conductive passages (4) of at least
partially 0.5 mm or less wide, made of fine pitched
conductive passages formed on the base-film (3) through adhesive (2), and coated with substantially insulative adhesive (1) which is melted at temperatures lower than that required to melt the base-film (3).

The conductive passages (4) of the invention must be at least partially 0.5 mm or less wide. Accordingly in bonding LSI to printed circuit boards, bonding pressure must be maintained at several hundred kg/cm$^2$ or less which requires the conductive passages to be at least partially of 0.5 mm wide or less.

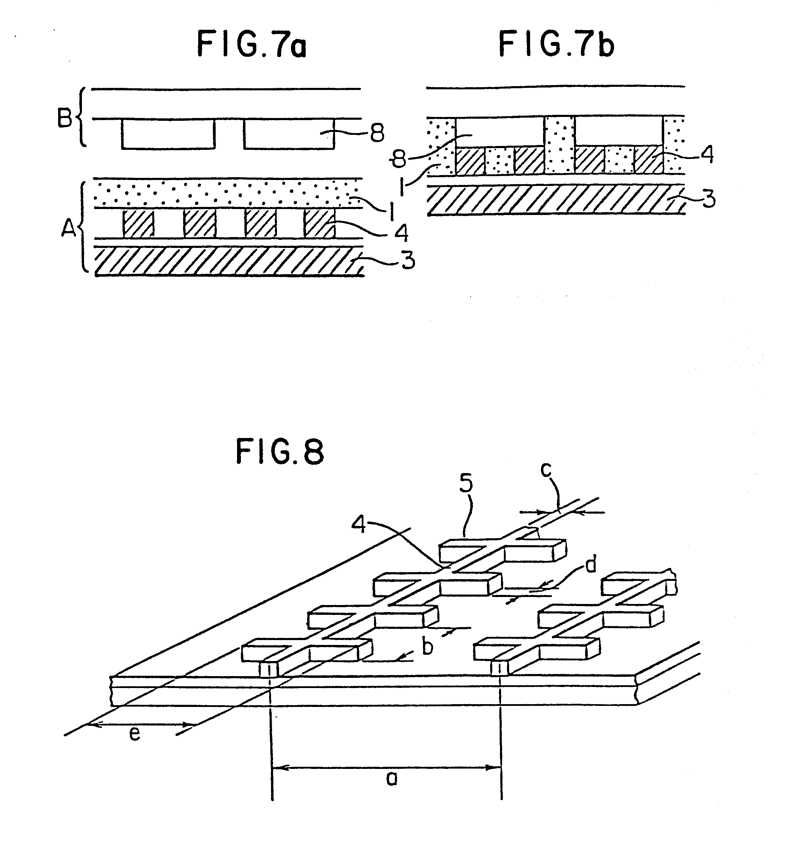

As shown in Fig. 2 and 8, the width of the passage (4) may exceed 0.5 mm if auxiliary structures (5) of partially 0.5 mm wide portions are provided on both sides of the passage (4).

The conductive passages (4) may have minute convexes and concaves (6) as shown in Fig. 3 or the conductive passages (4) as shown in Fig. 4 may preferably have a pointed end (7) to provide a stabilized connection at lower bonding pressure.

The connector of the invention may be manufactured by laminating metal foil on polyester film used for flexible printed circuit board and by providing the conductive passages by etching and by covering them with insulative adhesive or laminating the adhesive over them.

The conductive passages of this invention may be made of copper wires, stainless steel wires or nickel wires.

Films made of polyester or polyimide may be used for the base-film. Polyester may be preferred since it is inexpensive and flexible at bonding temperatures.

The adhesive layer of this invention may be made of any adhesives capable of bonding the passages and members including insulative adhesives of pressure sensitive, heat sensitive, photo-hardening and electron beam hardening types. These include numerous resins of rubber, polyester, polyamide, poly (meta) acryl, ethylenevinyl acetate, polyamide-phenol, polyamide-epoxy, terpene and aliphatic groups. These resins may contain tackifier or non-conductive particles.

The thickness of the insulative adhesive of this invention is not particularly limited but the preferred thickness may be:

$$T = \frac{H \ (P - W)}{P} \text{ or less}$$

Where: H is the thickness of conductive passage,
P is the pitch of conductive passage,
T is the thickness of adhesive,
W is the width of conductive passage.

The connector of this invention is bonded to members by applying heat and pressure on the bonded side of the connector (A) and the terminal 8 of the members (B) to form the highly reliable conductive passages as illustrated in Fig. 7.

One example of effective application of this invention is to flexible printing circuit board. Many kinds of parts of other circuit boards may be bonded with heat and pressure through adhesive films of the terminals of parts to be mounted on flexible printing or other circuit boards are designated at least partially 0.5 mm or less wide. Mounting of parts or bonding to other circuit boards may be made easier if adhesive films are formed in advance over the entire surface or terminals of flexible circuit board.

The invention is further described by referring to the following non-limiting examples.

In the examples, connectors are bonded using Teflon adhesive tape (No. 61 Scotch Tape made by Sumitomo 3M) pasted on metallic head of 6 mm wide. The bonding temperatures are measured on the surface of the bonding head.

## Example 1

The tape connector of the invention, a illustrated in Fig. 1, was made by laminating polyester adhesive film (K-1294, Toray) after applying ordinary etching using positive type photo resist to copper/polyester film laminate on the market (Cu/PET of 35/25 $\mu$ in thickness, made by Nikkan Kogyo, 10T-25C11).

Several types of tapes with different width and pitches were made and bonded to glass-epoxy printed circuit (copper/glass-epoxy, 35/1000$\mu$ thick) on which a conductor of the same width and pitch with the tape connectors are formed. The mean resistance of electrical connection and the number of defective terminals (open terminals) were evaluated and the results are shown in the Table 1.

## TABLE 1

| Flat Cable (mm) | | Bonding Condition | | Mean Resistance (ohms) | Number of Open Terminals |
|---|---|---|---|---|---|
| Conductor width | Conductor pitch | Temperature (%) | Pressure (Kg/cm$^2$) | | |
| 0.1 | 0.8 | 170 | 25 | 0.63 | 0 |
| | | 185 | 5 | 0.70 | 0 |
| | | | 25 | 0.69 | 0 |
| | | | 75 | 0.69 | 0 |
| | | 220 | 25 | 0.61 | 0 |
| 0.2 | 0.8 | 170 | 25 | 0.65 | 0 |
| | | 185 | 5 | – | 12 |
| | | | 25 | 0.46 | 0 |
| | | | 75 | 0.32 | 0 |
| | | 220 | 25 | 0.28 | 0 |
| 0.2 | 0.4 | 170 | 25 | 0.55 | 4 |
| | | 185 | 5 | – | 11 |
| | | | 25 | 0.50 | 0 |
| | | | 75 | 0.23 | 0 |
| | | 220 | 25 | 0.18 | 0 |
| 0.4 | 0.8 | 170 | 25 | – | 14 |
| | | 185 | 5 | – | 14 |
| | | | 25 | 0.6 | 4 |
| | | | 75 | 0.45 | 0 |
| | | 220 | 25 | – | 11 |
| 0.6 | 0.8 | 170 | 25 | – | 14 |
| | | 185 | 5 | – | 14 |
| | | | 25 | – | 9 |
| | | | 75 | – | 8 |
| | | 220 | 25 | – | 13 |

**TABLE 1 cont.**

| Flat Cable (mm) | | Bonding Condition | | Mean | |
|---|---|---|---|---|---|
| Conductor width | Conductor pitch | Temperature (%) | Pressure $(Kg/cm^2)$ | Resistance (ohms) | Number of Open Terminals |
| 0.6 | 1.2 | 170 | 25 | – | 14 |
| | | 185 | 5 | – | 14 |
| | | | 25 | – | 14 |
| | | | 75 | – | 14 |
| | | 220 | 25 | – | 14 |

Bonded to: Copper/glass-epoxy, Bonding time: 10 sec.
Thickness of Adhesive: 18 micron, number of evaluated terminals: 14 terminals/sample

Example 2

A tape connector of the invention was made in the same manner as in Example 1 and was bonded to conductive glass (indiumtin) to obtain the mean resistance, the number of open terminals and short-circuit between adjacent terminals which are shown in Table 2.

Flat cables without laminated adhesive were made in the same manner as above and bonded to conductive glass using the anisotropic conductive adhesive made in the manner described below and results are also shown for comparison.

Preparation of anisotropic conductive adhesive:

One side of a copper foil having a thickness of 20 microns was coated with polyester adhesive (K-1294, Toray) and the other side coated with positive type photo resist (OFPR RF 3FH315, Tokyo Oka Kogyo Co.) having a thickness of 3 microns. The resist surface is exposed to high pressure mercury lamp (JP-200, Oku Seisakusho) through positive film (Startaint 150 lines/inch, 70%, Sakurai Co., Ltd.) for 30 seconds and developed for one minute with 1% aq-NaOH solution at 25°C. The resist surface was then etched with 42% ferrous chloride solution. After removing residual resist by 3% NaOH, polyester adhesive was laminated on the copper foil to obtain the anisotropic conductive adhesive. The diameter of the copper particles of anisotropic conductive adhesive obtained in this method is 60 micron.

As shown in Table 2, the connector of the invention has a firm electrical connection even after a lapse of time while the anisotropic conductive adhesive compared showed open terminals and short circuits in addition to a high initial resistance and numerous open terminals were created after a lapse of time.

## TABLE 2

| Conductor | | | | Initial Value | | | After Aging | |
|---|---|---|---|---|---|---|---|---|
| | Width (mm) | Pitch (mm) | Adhesive thickness ($\mu$) | Mean resistance (ohms) | Number of open terminals | Short-circuit | Mean resistance (ohms) | Number of open terminal |
| Connector of this Invention | 0.1 | 0.8 | 5 | 160 | 0 | 0 | 210 | 0 |
| | | | 20 | 185 | 0 | 0 | 210 | 0 |
| | 0.2 | 0.8 | 5 | 280 | 0 | 0 | 320 | 0 |
| | | | 20 | 295 | 0 | 0 | 310 | 0 |
| | 0.2 | 0.4 | 5 | 270 | 0 | 0 | 330 | 0 |
| | | | 20 | 275 | 0 | 0 | 325 | 0 |
| Anisotropic Conductive Adhesive | 0.1 | 0.8 | 15 | 350 | 2 | 0 | 1200 | 7 |
| | | | 30 | 360 | 2 | 0 | 1350 | 11 |
| | 0.2 | 0.8 | 15 | 320 | 1 | 0 | -- | 14 |
| | | | 30 | 370 | 1 | 0 | -- | 22 |
| | 0.2 | 0.4 | 15 | 320 | 0 | 0 | -- | 22 |
| | | | 30 | 320 | 0 | 4 | -- | 28 |

Bonded to: ITO Glass  
Bonding Condition: 185°C, 10 sec., 25 kg/cm$^2$  
Evaluated Terminals: 35 terminals/sample  
Aging Conditon: 0.5 hrs Time lapse  
          -20°C (hrs)   70°C, 90% RH (2 hrs) (168 hrs)  
          0.5 hrs

## Example 3

As shown in Example 1, electrical continuity is not formed if the conductor on the tape connector is too wide. This drawback is removed by the tape connector of the invention having minute auxiliary structures partially made on each conductor as illustrated in Fig. 8. In Fig. 8, (a) was 2.0 mm, (b) 0.6 mm, (c) 0.15 mm, (d) 0.08 mm and (e) 1.0 mm. The tape connectors thus obtained are bonded to conductive glass and the results after a lapse of time under various conditions are shown in Table 3. No defective continuity (open terminals) was observed. In this case, the conductor on the tape connectors had been silver-plated in advance.

**TABLE 3**

| Aging Condition | Number of tested terminals | Means resistance after-aging (Ohms) |
|---|---|---|
| Initial value | 800 | 250 |
| 90°C, 1000 hrs | 200 | 180 |
| 80°C, 95% RH, 1000 hrs | 200 | 160 |
| Heat impact<br>-30°C (10 min)   100°C (10 min)<br>50 cycle | 200 | 300 |
| Heat cycle     1 hr<br>-40°C (2 hrs)     105°C (2 hrs)<br>1 hr<br>1000 hrs | 200 | 270 |

Cu/PET Laminate:  35/25$\mu$

Adhesive:  Toray K-2194, 18$\mu$ in thickness

Bonded to:  ITO Glass

Bonding condition:  Temperature — 185°C
Pressure — 50 kg/cm$^2$
Time — 10 sec.

## Example 4

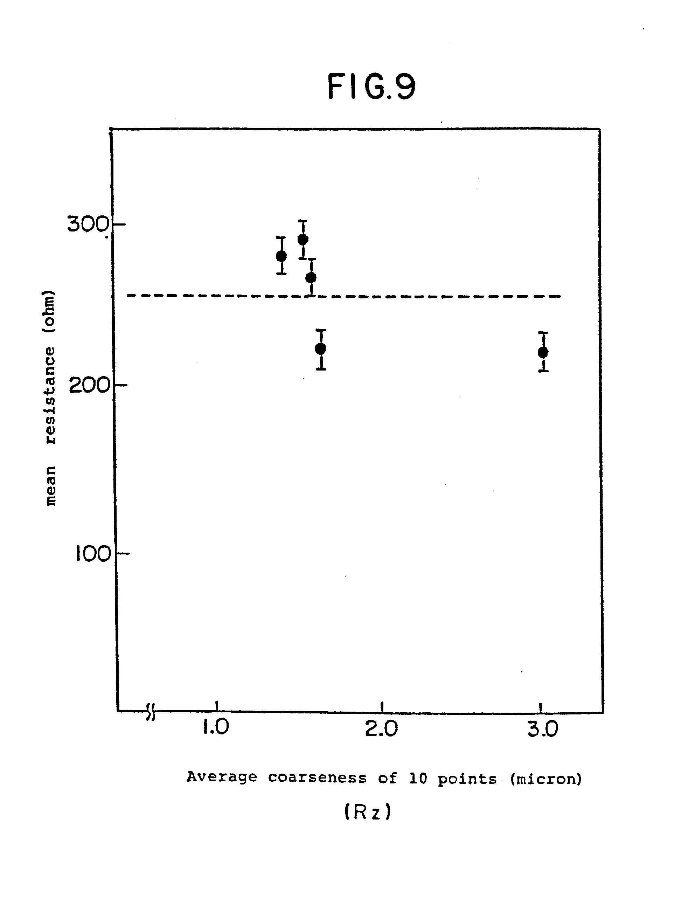

The surface of copper/polyester laminate (copper/polyester of 35/25 $\mu$ in thickness) was treated with sand paper of different grains and made into tape connector (0.2 mm of conductive width, 0.4 mm of conductors pitch) similar to the Example 1 and bonded to conductive glass. The results obtained are shown in Table 4 and Fig. 9.

A substantial decrease in resistance was observed when the surface coarseness (average coarseness of 10 points RZ JIS B0601-1982) of the conductor over the tape connector was 1.65 $\mu$ or over (standard length: 2.5 mm).

The copper surface of copper/polyester laminate is sandblasted to surface coarseness of 3.45 $\mu$. Tape connector made of the copper/polyester laminate obtained was bonded to conductive glass. The resistances measured are shown in Table 4.

TABLE 4

| Width (mm) | Pitch (mm) | Surface | Surface coarseness | | Bonding pressure (Kg/cm$^2$) | Mean resistance (ohms) | Open Termina |
|---|---|---|---|---|---|---|---|
| | | | Average of 10 points (micron) | Peak Count | | | |
| 0.2 | 0.4 | Untreated | 1.42 | 183 | 25 | 279 | 0 |
| | | | 1.56 | 158 | 25 | 290 | 0 |
| | | Treated with sand paper | 1.60 | 189 | 25 | 266 | 0 |
| | | | 1.65 | 190 | 25 | 221 | 0 |
| | | | 3.04 | 175 | 25 | 220 | 0 |
| 0.2 | 0.8 | Untreated | 1.42 | 183 | 25 | 270 | 0 |
| 0.4 | | | – | – | 25 | – | 15 |
| 0.6 | | | – | – | 25 | – | 45 |
| 0.2 | | | – | – | 75 | 520 | 0 |
| 0.4 | | | – | – | 75 | 540 | 0 |
| 0.6 | | | – | – | 75 | – | 25 |
| 0.4 | 0.8 | | 3.45 | 153 | 25 | 220 | 2 |
| | | Treated with sandblast | – | – | 75 | 180 | 0 |
| 0.6 | | | – | – | 25 | – | 4 |
| | | | – | – | 75 | 480 | 0 |

Surface courseness:  JIS B0601-1982
Cu/PET Laminate: 35/25$\mu$
Adhesive: Toray K-1294, 18$\mu$
Bonded to: ITO Glass
Number of terminals evaluated: 50 terminals/sample
Bonding conditon: Temperature – 185°C
            Time – 10 sec.

0237176

## Example 5

A tape connector of the invention similar to that of Example 3 was made from a copper/polyester laminate of different thickness and bonded to conductive glass. The results are shown in Table 5. Resistance was somewhat higher but still well within the practical range obtained when the thickness of copper/PET is 35 to 50 $\mu$.

## TABLE 5

| Thickness ($\mu$) | | | Initial value | | After aging | |
|---|---|---|---|---|---|---|
| Cu | PET | Adhesive | Resistance (Ohm) | Number of open terminals | Resistance (Ohm) | Number of open terminals |
| 35 | 50 | 20 | 323 | 0 | 546 | |
| 35 | 25 | 20 | 290 | 0 | 292 | |
| 18 | 25 | 10 | 381 | 0 | 381 | |

Bonded to: ITO Glass

Bonding Condition: Temp. — 185°C

Pressure — 50 kg/cm$^2$

Time — 10 sec.

Number of evaluated terminals: 40 terminals/sample

Aging Condition: Heat impace

−30°C    100°C, 50 cycles

(10 min) (10 min)

Example 6

Flat cables having a structure similar to that of Example 3 were made with adhesives and resins of different thickness and bonded to conductive glass and the results are shown in Table 6.

Acrylic adhesive (W-248-E of Negami Kogyo Co., Ltd.) of 30 $\mu$ and thickness had higher resistance than those of other thickness and open terminals were observed in case of 40 $\mu$ thick adhesive.

Polyester resin (K-1294, Toray Co., Ltd.) produced no open terminals but exhibited somewhat higher resistance in case of 40 $\mu$ thickness than those of other thickness.

Either resin of 20 $\mu$ or less thickness has substantially low resistance.

## TABLE 6

| | Adhesvie | | |
|---|---|---|---|
| Type | Thickness ($\mu$) | Mean resistance (Ohm) | Number of open terminals |
| W-248-E | 10 | 198 | 0 |
| | 20 | 261 | 0 |
| | 30 | 440 | 0 |
| | 40 | – | 10 |
| K-1294 | 10 | 265 | 0 |
| | 20 | 295 | 0 |
| | 30 | 352 | 0 |
| | 40 | 478 | 0 |

W-248-E:  Polyacrylate (Negami Kogyo)

K-1294:  Polyester (Toray)

Cu/PET laminate:  35/25$\mu$

Bonded to:  ITO Glass

Bonding conditions:  Temp. – 185°C

Pressure – 50 kg/cm$^2$

Time – 10 sec.

Number of evaluated terminals: 20 terminals/sample

Example 7

Tape connectors of the invention similar to that of Example 1 were made using polyester resin (K-1294, Toray Co., Ltd.), phenoxy resin (PKHH, Union Carbide) and Rubber resin (JA7413-R, Sumitomo 3M) as adhesives, and bonded to conductive glass at different temperatures. The results are shown in Table 7.

None of these resins provided substantial continuity at a wide range of bonding temperatures when the width of conductors were 0.6 mm. No appropriate continuity was obtained even when the bonding pressure was raised to 200 kg/cm$^2$, many conductive glasses were broken and the conductors on the tape connector were damaged in some cases during the test.

All of these adhesives provided substantial continuity by selecting appropriate bonding conditions when the width of conductor was 0.4 mm. In all these resins resistance gradually increased when the bonding temperatures were too high and open terminals were observed. In this case numerous bubbles were observed between conductors of the tape connector. This was also observed with adhesive completely dried in advance at high temperatures. In the case of polyester adhesives, deformation of tape connectors bonded at various temperatures (cave-in of polyester substrate between conductors) was measured with a surface roughness meter. The results obtained (depth of depression) are as follows:

| Bonding temperature | Depression of polyester substrate ($\mu$) |
|---|---|
| 180°C | 28 |
| 210°C | 22 |
| 240°C | 11 |

It is surmised that at high temperatures resins become excessively volatile and polyester film deformed under pressure regains the form when bonding pressure is removed, producing bubbles and increasing resistance.

From the above test results, it is clear that the width of the conductive passage must be 0.5 mm or less, or preferably 0.4 mm or less to form stable continuity in case of a conductor with smooth surface.

41694EPO4A **0237176**

CLAIMS:

1. A connector comprising conductive passages which are at least partially of 0.5 mm or less in width, said fine pitched conductive passages formed on a base film and coated by a substantially insulative adhesive melting at lower temperatures than that of the said base film.

2. The connector of claim 1 wherein said conductive passages which are at least partially of 0.4 mm or less in width.

3. The connector of claim 1 wherein said conductive passages have a width of 0.5 mm or less.

4. The connector of claim 1 wherein said conductive passages have fine convexes and concaves on the surface of said conductive passage.

5. The connector of claim 1 wherein said conductive passages are made of a metallic material.

6. A process for making electrical connection by heating and pressing two pairs of diametrically opposed conductive passages by use of a substantially insulative adhesive, characterized by making at least one of said diametrically opposed conductive passages to be at least partially 0.5 mm or less in width and providing said adhesive between diametrically opposed conductive passages.

7. The process of claim 5 wherein said conductive passages were small convexes and concaves on the surface of at least one of said conductive passages.

FIG.1a

FIG.1b

FIG.1c

FIG.2

FIG.3

## FIG.4

## FIG.5

## FIG.6

# FIG.7a

# FIG.7b

# FIG.8

FIG.9

FIG.10a

FIG.10b

FIG.11a

FIG.11b